# EUROPÄISCHE PATENTSCHRIFT

(11) **EP 2 912 778 B1**
(45) Veröffentlichungstag und Bekanntmachung des Hinweises auf die Patenterteilung: **26.06.2019**
(21) Anmeldenummer: 13785396.6
(22) Anmeldetag: 24.10.2013
(51) Int. Cl.: H04B 5/00

(54) **MODULARES ELEKTRONIKSYSTEM UND BUSTEILNEHMER**
MODULAR ELECTRONIC SYSTEM AND BUS SUBSCRIBER
SYSTÈME ÉLECTRONIQUE MODULAIRE ET ABONNÉ DU BUS

(30) Priorität: 24.10.2012 DE 102012110173
(43) Veröffentlichungstag der Anmeldung: 02.09.2015
(73) Patentinhaber: Phoenix Contact GmbH & Co. KG, 32825 Blomberg (DE)
(72) Erfinder: KALHOFF, Johannes, 32825 Blomberg (DE); SCHOLZ, Peter, 33034 Brakel (DE)
(74) Vertreter: Blumbach · Zinngrebe Patentanwälte PartG mbB
(86) Internationale Anmeldenummer: PCT/EP2013/072303
(87) Internationale Veröffentlichungsnummer: WO 2014/064208

(56) Entgegenhaltungen:
- EP-A1- 1 885 085
- EP-A2- 2 073 315
- US-A1- 2009 237 194
- US-A1- 2011 127 845

## Beschreibung

### Gebiet der Erfindung

Die Erfindung bezieht sich auf ein modulares Elektroniksystem zur Aufnahme, Verarbeitung oder Weitergabe von Information, insbesondere in Verbindung mit einem Bussystem und einer Anzahl von Teilnehmergeräten sowie auf einen einzelnen Busteilnehmer.

### Hintergrund der Erfindung

EP 1 484 511 B1 zeigt ein Verkettungsmodul zur Ansteuerung eines elektrischen Ventilantriebs einer fluidtechnischen Ventilanordnung und umfasst ein Gehäuse mit daran angebrachten Verkettungskontakten zur elektrischen Kontaktierung eines weiteren Verkettungsmoduls. Dabei ist das Gehäuse als spritzgegossener, räumlicher Schaltungsträger in der Bauart eines Molded Interconnect Devices (MID) ausgestaltet und enthält Leiterbahnen sowie elektrische Komponenten für Steuer- und Überwachungsfunktionen und/oder für eine Kommunikationsfunktion.

Aus DE 197 19 730 C1 ist eine Steckverbindung für einen explosionsgefährdeten Bereich zur Energie- und Datenübertragung zwischen mindestens einem elektrischen Verbraucher und einem Bussystem bekannt, bei der ein Übertrager aus Primärteil und Sekundärteil vorgesehen ist, die trennbar und verbindbar jeweils in Steckerhälfte-Gehäuse angeordnet sind. In dem Primärteil-Gehäuse ist eine Begrenzereinrichtung für elektrische Größen (Strom/Spannung) vorgesehen, während das Innere des Sekundärteil-Gehäuses dem explosionsgefährdeten Bereich zuordenbar ist.

Die US 2009/0237194 A1 bezieht sich auf ein Gerät, ein System und ein Verfahren zur Ermöglichung der elektromagnetischen Energieübertragung zwecks Aufladung von Batterien von elektronischen Geräten. Es ist eine Ladestange mit nebeneinander angeordneten Generatorspulen vorgesehen, denen jeweils ein Sensor zugeordnet ist, um festzustellen, ob sich ein elektronisches Gerät in Überdeckung mit der jeweiligen Generatorspule befindet. In dem elektronischen Gerät gibt es eine Schaltungsplatine mit einer flach ausgebildeten Empfangswindung, die über einen Kondensator und einen Gleichrichter mit der aufzuladenden Batterie des Geräts verbunden ist.

Aus EP 1 885 085 A1 ist die berührungslose Energie- und Datenversorgung von Busteilnehmern bekannt, bei der eine Vorrichtung zur mechanischen Halterung, elektrischen Energieversorgung und Datenversorgung von Busteilnehmern in Form eines Regals mit Einsteckplätzen für kastenartig ausgebildete Busteilnehmer vorgesehen ist. Jeder Einsteckplatz umfasst eine Energieübertragungsschnittstelle und eine Datenübertragungsschnittstelle, die mit einer Energieübertragungsschnittstelle und einer Datenübertragungsschnittstelle des jeweiligen Busteilnehmers kooperieren. Diese Schnittstellen sind auf der Rückseite des Busteilnehmers dargestellt.

Die EP 2 073 315 A2 bezieht sich auf ein modulares Datenübertragungssystem mit separater Energieversorgung für jedes angeschaltete Modul, die jeweils Busteilnehmer darstellen. Diese weisen jeweils in einer Ebene eine Schaltungseinrichtung und in einer benachbarten Ebene Übertragungselemente zu benachbarten Busteilnehmern auf, so dass ein drahtloser Datenverkehr zwischen benachbarten Busteilnehmern ermöglicht wird.

Die US 2011/0127845 A1 zeigt eine Anordnung zur drahtlosen Übertragung von elektrischer Energie zu Betriebszwecken und zu Informationsübermittlungszwecken.

Elektronische Geräte müssen teilweise sehr kompakt gebaut werden, dass heißt es muss mit Platzproblemen geschickt umgegangen werden. Gleichzeitig wird eine gute Isolation und Spannungsfertigkeit von Elektronikkomponenten der Geräte, insbesondere bei explosionsgefährdeten Bereichen, verlangt.

Mit Bussystemen arbeitende Elektroniksysteme weisen häufig eine Schiene zur Aufnahme von Teilen des Bussystems und zur Steckbefestigung von Teilnehmergeräten auf. Die Teilnehmergeräte beherbergen gewöhnlich eine oder mehrere Leiterplatten, die mit Elektronikkomponenten bestückt sind, welche Signale empfangen, verarbeiten und abgeben. Die Energiezufuhr sowie die Signalzu- und -abfuhr erfolgt über das Bussystem. Die Leiterplatten können ein- oder mehrlagige Schichtaufbauten beinhalten, es können aber auch flexible oder andere dreidimensionale Leiterstrukturen mit kontaktierten Elektronikkomponenten verwendet werden. Die genannten Aufbauten werden im Folgenden vereinfachend als Leiterplatte bezeichnet.

An die Teilnehmergeräte des Bussystems werden diverse Anforderungen gestellt. Aus Gründen der Sicherheit soll der Busteilnehmer galvanisch von seiner Energiequelle und Datenschnittstelle getrennt werden. Auch wird eine schmale Baubreite der Teilnehmergeräte angestrebt, um viele Geräte nebeneinander auf einer Trägerschiene unterbringen zu können.

### Allgemeine Beschreibung der Erfindung

Der Erfindung liegt die Aufgabe zugrunde, ein modulares Elektroniksystem bereitzustellen, das eine kompakte Bauweise bei guter Isolation der Elektronikkomponenten ermöglicht. Insbesondere soll eine platzsparende Energieversorgung von Elektronikgeräten ermöglicht werden.

Diese Aufgabe wird durch den Gegenstand der unabhängigen Ansprüche gelöst. Vorteilhafte Ausgestaltungen und Weiterbildungen sind in den abhängigen Ansprüchen angegeben.

Der Begriff "elektromagnetisch wirksame Elektronikkomponente" meint ein induktives oder kapazitives Koppelglied aus Spule, Antenne oder Kondensatorplatte. Der Begriff "Anschlusseinrichtung" bezeichnet eine galvanische oder eine elektromagnetische Verbindung zu einem Elektronikgerät zu Zwecken der Zufuhr von elektrischer Betriebsenergie und/oder Signalenergie (mit Informationsgehalt). Der Begriff "flach" bezeichnet ein Bauelement, dessen Ausdehnung in einer Ebene wesentlich größer ist als in senkrechter Richtung zu der Ebene.

Der Begriff "Bussystem" umfasst im Kontext dieser Anmeldung auch einen reinen Bus für die Energieversorgung der Busteilnehmer. So kann ein Bussystem beispielsweise aus nur zwei Leitungen aufgebaut sein, über die eine Gleichspannung bereitgestellt wird, die von verschiedenen Busteilnehmern über Kontaktverbindungen abgegriffen wird. Somit wird auch eine einzelne Spannungsquelle, an die mindestens zwei Busteilnehmer parallel angeschlossen sind, als Bussystem bezeichnet.

Der Begriff "modular" kann bedeuten, dass zum Beispiel der Busteilnehmer in das Gesamtsystem eingefügt und aus dem Gesamtsystem herausgenommen werden kann, ohne dass die Funktionalität des Gesamtsystems dadurch beeinflusst oder beeinträchtigt wird. "Modular" kann auch bedeuten, dass die Funktionen des elektrischen Geräts, zum Beispiel des Busteilnehmers mittels Erweiterungskarten erweitert werden können, so dass das elektrische Gerät, zum Beispiel der Busteilnehmer nicht schon in der Fertigungsphase mit allen Funktionen ausgestattet werden muss.

Ein Aspekt der Erfindung betrifft die Ausbildung des Gehäuses für ein elektrisches Gerät, insbesondere einen Busteilnehmer, der beispielsweise ein Messgerät, ein Automatisierungsmodul oder ein Steuergerät darstellen kann.

An oder in einem der Gehäuseteile kann mindestens ein erstes Übertragungselement angeordnet sein, das als Primärspule eines Transformators oder als Sendeantenne zum induktiven Einkoppeln elektrischer Energie in ein zweites Übertragungselement (Sekundärspule) ausgebildet ist. Die Gehäusewand kann mehrschichtig aufgebaut sein, wobei das erste Übertragungselement (die Primärspule) in einer Zwischenschicht angeordnet wird.

Das elektrische Signal kann ein Mess- oder Datensignal sein, daneben kann auch die Energie zum Betrieb der Elektronikkomponenten des Geräts übertragen werden. Das Mess- oder Datensignal wird vorzugsweise getrennt von der Betriebsenergie übertragen, es ist aber auch eine gleichzeitige Übermittlung von Energie und Informationen über dieselben Übertragungselemente möglich, beispielsweise durch Aufmodulation von Daten auf einen Energiestrom.

Mit anderen Worten, in dem Gehäuse kann ein Transformator angeordnet sein, wobei die Primärspule des Transformators, als Teil des Gehäuses, in oder an der Gehäusewand angeordnet ist, und die Sekundärspule des Transformators im Inneren des Gehäuses an oder mit oder in einer Leiterplatte angeordnet wird.

Die Einspeisung in die Primärspule wird vorzugsweise mittels eines galvanischen Kopplers, beispielsweise eines Steckers ausgeführt, es kann aber auch ein kapazitiver oder induktiver Koppler verwendet werden. Die beiden letzgenannten Koppler haben den Vorteil, dass keine kontaktbehaftete Verbindung zwischen der Anschlusseinrichtung zum Beispiel zu einem Bussystem und dem elektrischen Gerät besteht und somit beispielsweise eine gute Kapselung des Gehäuses zum Schutz gegenüber äußeren Einwirkungen möglich ist.

Die erfindungsgemäße Bauweise ermöglicht eine kontaktfreie Einspeisung elektrischer Energie und oder Daten/Signale für die im Gehäuse untergebrachten Elektronikkomponenten, die somit galvanisch von der Energiequelle getrennt sind. Gleichzeitig erfolgt eine Reduktion des für die Elektronikkomponenten benötigten Raums.

Die mit dem Gehäuse erzielten Vorteile sind somit:
- Platz- und Kostenersparnis bei der Implementierung der Elektronikkomponenten,
- galvanische Trennung der Elektronikkomponenten von der Energiequelle, und
- Vereinfachung der Energieversorgung der Elektronikkomponenten.

Ein weiterer Aspekt der Erfindung betrifft ein modulares Elektroniksystem mit mindestens einem elektrischen Gerät zum Beispiel Busteilnehmer, das ein Elektronikmodul, wie beispielsweise ein Messgerät, Automatisierungsmodul oder Steuergerät sein kann.

Das elektrische Gerät, zum Beispiel Busteilnehmer kann eine elektronische Schaltung umfassen, die in einem Innenraum oder einer Wand des Teilnehmergehäuses angeordnet ist.

Die elektronische Schaltung kann als ein elektrisches Betriebsmittel, beispielsweise ein Relais, Stromstoßschalter, Zeitschaltuhr, oder Sicherungsautomat, oder als ein Messgerät, Automatisierungsmodul, Trennverstärker oder Steuergerät ausgebildet sein.

Das elektrische Gerät, zum Beispiel der Busteilnehmer kann folgende Komponenten umfassen:
- ein Gehäuse,
- eine in dem Gehäuse angeordnete elektronische Schaltung, und
- einen Transformator mit mindestens einer Primär- und mindestens einer Sekundärspule zur elektromagnetischen Übertragung elektrischer Energie umfassend die Energieversorgung sowie gegebenenfalls auch ein Datensignal an die mit der Sekundärspule gekoppelte elektronische Schaltung.

Die Energieversorgung kann als eine hochfrequente Spannung bereitgestellt werden, um die Baugröße der Übertragungselemente klein halten zu können. Hochfrequent bezeichnet in Kontext dieser Erfindung Frequenzen im kHz (Kilohertz) Bereich und höher bis in den Megahertz-Bereich.

Die Einspeisung in die Primärspule kann mittels eines galvanischen Kopplers, beispielsweise eines Steckers, erfolgen, wenn die hochfrequente Spannung von den Energieversorgungseinheiten, zum Beispiel des Bussystems, geliefert wird. Andernfalls wird hochfrequente Spannung aus Gleichstrom oder Wechselstrom, zum Beispiel des Bussystems, erzeugt.

Vorteilhafte Ausgestaltungen und Weiterbildungen sind nachfolgend angegeben. Die Merkmale der Weiterbildungen können, soweit technisch sinnvoll, miteinander und mit jedem der Aspekte der Erfindung kombiniert werden.

Gemäß einer Ausführungsform kann die Primärspule eingespritzt, als ein Molded Interconnect Device (MID) in einer Energie-Übertragungswand des Gehäuses, isoliert und gekapselt ausgebildet sein.

Die Primärspule wird als eine flache, spiralförmige Spule oder Antenne dünn gewickelt oder auf Substrat gedruckt oder aus niedergeschlagenen Schichten heraus geätzt hergestellt. Die Sekundärspule kann ähnlich oder mit gleicher Technologie wie die Primärspule ausgebildet sein. Das heißt, die Sekundärspule kann als ein Molded Interconnect Device (MID), oder als eine spiralförmige Spule oder Antenne, oder als eine eingespritzte Spule oder dünn gewickelte Spule gedruckt oder "geätzte" Spule in oder auf der Leiterplatte des Teilnehmergerätes ausgebildet sein.

Der Transformator kann zwei oder mehrere Sekundärspulen, aber auch zwei oder mehrere Primärspulen umfassen, die elektromagnetisch gekoppelt sind.

In einer bevorzugten Ausführungsform weist das Elektroniksystem einen Bus auf, an welchem mehrere Teilnehmergeräte angeschlossen werden können.

Der Bus kann als T-Bus ausgebildet sein und vorzugsweise ein TCP/IP Protokoll implementieren, wobei die Busteilnehmer über RS-485 oder Funk angebunden sein können.

Der Bus umfasst mehrere elektrische Leitungen, darunter können auch zwei Leitungen für die Energieversorgung und zwei oder drei Leitungen für den Datenstrom vorgesehen werden.

Die Leitungen des Bus können in oder an einer Tragschiene angeordnet sein. Die Tragschiene kann eine Profilschiene aus Metall sein, die zur Befestigung der Teilnehmergeräte dient. Die Tragschiene ist Teil des Rangiersystems der Busleitungen, welche die Speisespannung und die Kommunikationssignale den Teilnehmergeräten zuführen.

Die Tragschiene kann als eine Hutschiene ausgebildet sein. Die Hutschiene, beispielsweise eine TS-35 oder DIN-Schiene, ist eine Tragschiene mit U-förmigem oder Hut ähnlichem Profil. Im Englischen wird die Hutschiene als eine "DIN Rail" mit Abmessungen von 35 x 7,5 mm bezeichnet.

Der Bus kann auch auf einem hybriden Übertragungsweg basieren, der eine elektrische Leitung für die Versorgungsspannung und eine Funkstrecke für Datensignale umfasst.

Das Elektroniksystem umfasst eine Anschlusseinrichtung, um den Busteilnehmer galvanisch oder kapazitiv und/oder induktiv an das Bussystem anzuschließen.

Die Anschlusseinrichtung ist an der Tragschiene angeordnet und verbindet die entlang der Tragschiene verlaufende Versorgungsleitung, gegebenenfalls über einen entsprechenden Wandler, galvanisch mit dem jeweiligen Teilnehmergerät. Hierzu kann die Anschlusseinrichtung als ein Stecker, T-Bus Element oder T-Bus Stecker ausgebildet sein.

Die Energieversorgungsspannung kann mit einem Datensignal moduliert sein. Hierbei können das Datensignal als niederfrequentes Nutzsignal und die Versorgungsspannung als hochfrequenter Träger angesehen werden.

Der Übertragungsweg der Datensignale kann vom Übertragungsweg der Energieversorgungsspannung verschieden sein. So kann beispielsweise die Energieversorgungsspannung via Leitung und das Datensignal via Funk, oder Datensignal und Energieversorgungsspannung über unterschiedliche Leitungen übertragen werden.

Gemäß einer Ausführungsform kann eine Weiche vorgesehen sein, um die Energieversorgungsspannung einer ersten Primärspule und das Datensignal einer zweiten Primärspule zuzuführen.

Alternativ kann die Energieversorgungsspannung und das Datensignal einer einzigen Primärspule zugeführt werden.

Die elektronische Schaltung kann in dem Gehäuse gekapselt (staubdicht eingeschlossen) sein.

Gemäß einer Ausführungsform kann der Busteilnehmer eine Einrichtung zur Abschirmung elektromagnetischer Felder umfassen, z. B. kann eine Ferritfolie das Teilnehmergehäuse umkleiden oder in der Gehäusewandung integriert sein.

Der Busteilnehmer kann eine Vorrichtung zur Bündelung der elektromagnetischen Feldlinien der Spulen, vorzugsweise einen Ferritkern, umfassen. Zu diesem Zwecke kann auch eine möglicherweise vorhandene Ferritfolie dienen.

Die Erfindung wird nachfolgend anhand von Ausführungsbeispielen und unter Bezugnahme auf die Zeichnungen näher erläutert. Dabei verweisen gleiche Bezugszeichen auf gleiche oder entsprechende Elemente. Die Merkmale verschiedener Ausführungsbeispiele können miteinander und mit jedem Aspekt der Erfindung kombiniert werden.

### Kurzbeschreibung der Figuren

Es zeigen:
- Fig. 1: eine Explosionsdarstellung eines Busteilnehmers in einer ersten Ausführungsform, schematisiert,
- Fig. 2: eine perspektivische Darstellung des Busteilnehmers nach Fig. 1 im Zusammenbau,
- Fig. 3: eine Explosionsdarstellung eines Busteilnehmers in einer zweiten Ausführungsform, schematisiert,
- Fig. 4: eine perspektivische Darstellung des Teilnehmergehäuses gemäß der ersten oder zweiten Ausführungsform und einer Hutschiene,
- Fig. 5: eine perspektivische Darstellung mehrerer Teilnehmergehäuse auf einer Hutschiene aufgesteckt,
- Fig. 6: eine als Seitenansicht dargestellten Schnitt durch ein Teilnehmergerät,
- Fig. 7: ein elektrisches Gerät mit mehreren Leiterplatten und elektromagnetischer Energieübertragung,
- Fig. 8: ein elektrisches Gerät mit einer Identifikationseinrichtung, und
- Fig. 9: ein elektrisches Gerät mit Trennverstärkerfunktion.

### Detaillierte Beschreibung der Erfindung

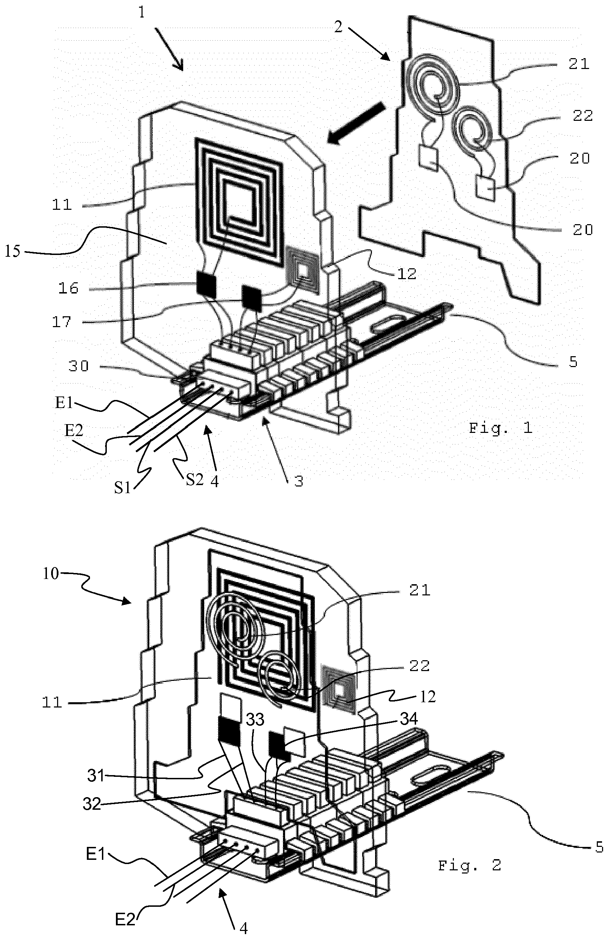

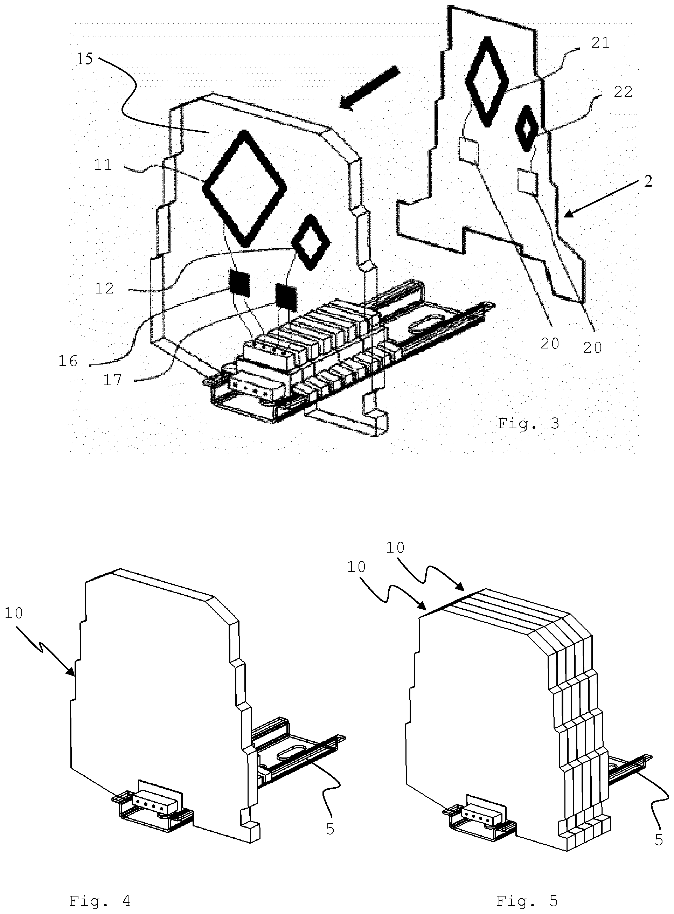

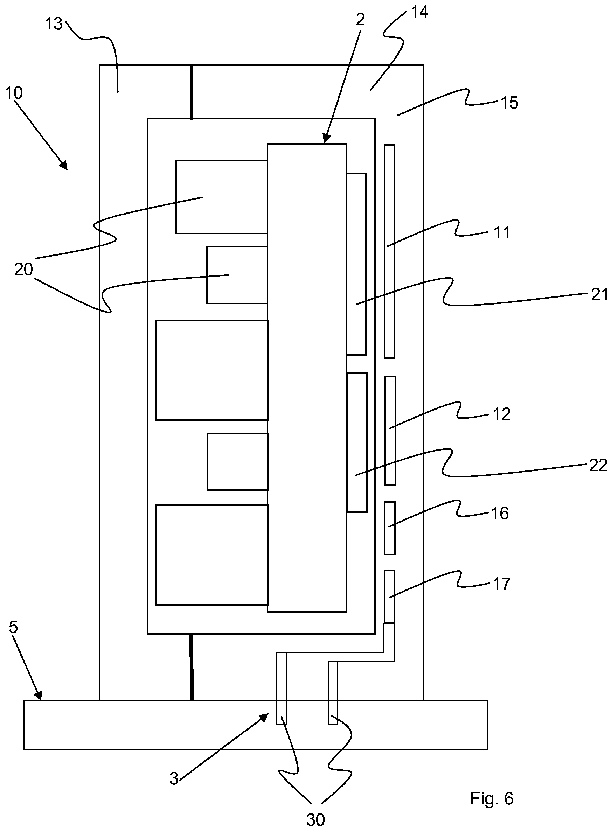

Die hauptsächlichsten Teile des modularen Elektroniksystems gemäß Erfindung sind eine Anzahl von Teilnehmergeräten 1, die in ihrem Gehäuse 10 jeweils eine bestückte Leiterplatte 2 aufweisen und die über eine jeweilige Anschlusseinrichtung 3 mit einem Bussystem 4 verbunden sind. Das Gehäuse 10 kann zwei einen Hohlraum umschließende Gehäusehälften 13, 14 aufweisen (Fig. 6), die die bestückte Leiterplatte 2 staubdicht oder gar gasdicht umschließen und somit einkapseln. Die Gehäusehälfte 14 weist eine Energie-Übertragungswand 15 mit mindestens einem ersten, flach ausgebildeten Primärübertragungselement 11 auf, das im Falle der Ausführungsform nach Fig. 1 und 2 als Flachspule und im Falle der Fig. 3 als Kondensatorplatte(n) ausgebildet ist. Auch wenn die Wand 15 nur teilweise von einem elektromagnetisch wirksamen Übertragungselement eingenommen wird, und unabhängig von Energie- oder Signalversorgung, wird die Wand 15 als "Energie-Übertragungswand" bezeichnet. Als Gegenstück zu dem ersten Primärübertragungselement 11 ist ein erstes Sekundärübertragungselement 21 vorgesehen, das im Falle der Fig. 1 und 2 als Flachspule und im Falle der Fig. 3 als Kondensatorplatte(n) ausgebildet ist. Das erste Sekundärübertragungselement 21 ist Teil der Leiterplatte 2 und dort durch bekannte Verfahren erzeugt und, falls gewünscht, in der Leiterplatte eingekapselt worden.

Bei den dargestellten Ausführungsbeispielen ist neben dem ersten Primärübertragungselement 11 ein zweites Primärübertragungselement 12 angeordnet, und im gleichen Sinne ist neben dem ersten Sekundärübertragungselement 21 ein zweites Sekundärelement 22 angeordnet. Die Paarungen an der ersten Übertragungselemente 11, 21 und der zweiten Übertragungselemente 12, 22 werden parallel zueinander betrieben. Hierzu sind Einspeiseelektroniken 16, 17 für den Energieteil und den Signalteil des Teilnehmergeräts vorgesehen, die den Übertragungselementen 12, 22 zugeordnet sind und in der Gehäusewandung 15 oder in der Anschlusseinrichtung 3 integriert angeordnet sein können. Die Anschlusseinrichtung 3 verbindet das Teilnehmergerät 1 mit dem Bussystem 4 elektrisch, wobei sowohl eine galvanische Verbindung als auch eine kapazitive oder induktive Kopplung über ein elektrisches oder elektromagnetisches Wechselfeld in Frage kommen.

Das Bussystem 4 umfasst Energieübertragungsleitungen E1 und E2, ferner mindestens zwei Signalleitungen S1 und S2, die sich parallel zueinander in einer Tragschiene 5 erstrecken. Diese Leitungen E1, E2, S1, S2 sind über die Anschlusseinrichtung 3 an das Teilnehmergerät 1 angeschlossen, wobei letztendlich die Verbindung zu Elektronikkomponenten 20 läuft, mit denen die Leiterplatte 2 bestückt ist.

Im Falle einer elektrischen Leitungsverbindung zu dem Teilnehmergerät 1 kann man die Anschlusseinrichtung 3 als Kontaktvorrichtung, insbesondere T-Bus Stecker 30, ausbilden, der die Busleitungen E1, E2, S1, S2 über Verbindungsleitungen 31, 32, 33, 34 mit den Einspeiseelektroniken 16 und 17 verbindet. Zu diesem Zweck ist das untere Ende des Teilnehmergerätes 1 als Anschlusssockel zur elektrischen Verbindung mit dem Stecker 30 und zur mechanischen Befestigung an der Schiene 5 ausgebildet. Hinsichtlich der Energieversorgung und der Signalversorgung des Teilnehmergeräts gibt es zwei Möglichkeiten: Man kann mit Gleichspannung oder mit Hochfrequenzwechselspannung auf den Signal- und Energieversorgungsleitungen E1, E2, S1, S2 arbeiten. Bei Verwendung von Gleichspannung wird in den Einspeiseelektroniken 16, 17 je eine hochfrequente Spannung erzeugt, mit der die Hochfrequenzenergie über die Primärübertragungselemente 11, 12 auf die Sekundärübertragungselemente 21, 22 übertragen werden kann. Die Elektronikkomponenten des Teilnehmergeräts umfassen Gleichrichterschaltungen, die die hochfrequenten Spannungen in Gleichspannungen wandeln, die als Betriebsspannung für die Signal verarbeitenden Elektronikkomponenten 20 bereit gestellt wird. Wenn die Energieleitungen E1, E2 des Bussystems Hochfrequenzspannungen führen, können diese Spannungen über die Stecker 30 der Anschlusseinrichtung 3 unmittelbar oder über die Einspeiseelektroniken aufbereitet den Primärübertragungselementen 11, 12 zugeführt werden.

Die Anschlusseinrichtung 3 kann auch als induktiver oder kapazitiver Übertrager ausgebildet sein, bei dem es Primär- und Sekundärübertragerelemente ähnlich zu den Übertragungselementen 11, 21; 12, 22 gibt. Insbesondere kommen induktive Übertrager in Betracht, bei denen die Primärspulen im Bereich der Tragschiene 5 angeordnet sind, während die Sekundärspulen sich oberhalb dieses Bereichs der Primärspulen befinden und bereits dem Teilnehmergerät angehören und in vorteilhafter Weise in der Energie-Übertragungswand 15 angeordnet sind.

Die Fig. 1 zeigt die erste Ausführungsform des Elektroniksystems vor dem Zusammenbau des Teilnehmergeräts 1 und Fig. 2 nach dem Zusammenbau. In dem Gehäuse 10 sind elektronische Schaltungen 20 und Transformatoren 11/21 sowie 12/22 angeordnet.

Die Transformatoren umfassen zwei Primärspulen 11, 12 und zwei Sekundärspulen 21, 22 zur elektromagnetischen Übertragung einer Hochfrequenzspannung, die in eine Energieversorgungsgleichspannung für die elektronische Schaltungen 20 umgewandelt wird. Die Primärspulen 11, 12 sind in der isolierenden Wand 15 des Gehäuses 10 eingeschlossen und somit gekapselt.

Man kann die Primärspulen 11, 12 der Transformatoren auch als spiralförmige Sendeantennen bezeichnen, ebenso die Sekundärspulen 21, 22 als spiralförmige Empfangsantennen. Die Einspeiseelektronik 16, 17 zu den Primärspulen 11, 12 kann als Teil der Anschlusseinrichtung 3ausgebildet werden, um durch induktive Kopplung mit den Sekundärspulen 21, 22 die Versorgung mit Energie und Datensignalen zu bewerkstelligen.

Die Energieleitungen E1, E2 sind mit der Primärspule 11 und die Signalleitungen S1, S2 mit der Primärspule 12 verbunden, um auf der Sekundärseite einerseits geeignete Spannung zum Betrieb der Elektronikkomponenten 20 und andererseits Mess- oder Datensignale zur Bearbeitung durch die Elektronikkomponenten 20 zu gewinnen. Insbesondere für Datensignale kann die Übertragungsrichtung auch umgekehrt werden, so kann beispielsweise die Spule 22 als Primär- und die Spule 12 als Sekundärspule eines Signalübertragers verwendet werden.

Die Sekundärspulen 21, 22 sind an oder innerhalb der Leiterplatte 2 untergebracht, desgleichen auch die Elektronikkomponenten 20. Die Darstellung ist stark schematisiert. Die reale Anordnung der Leiterplatte 2 innerhalb des Gehäuses ergibt sich aus Fig. 6.

Fig. 2 zeigt die Überdeckung der Primär- und Sekundärspulen zur Bildung von Transformatoren oder Wandlern. Es können auch ungleiche Anzahlen von Primär- und Sekundärübertragugselementen verwendet werden. So kann beispielsweise eine Primärspule mit zwei Sekundärspulen elektromagnetisch gekoppelt sein.

Die Fig. 3 zeigt eine zweite Ausführungsform des Elektroniksystems. Die Energieübertragungswand 15 nimmt, eingekapselt in ihrem Inneren, Kondensatorplatten als Primärübertragungselemente 11, 12 und Einspeiseelektroniken 16, 17 auf, während die Leiterplatte 2 Kondensatorplatten als Sekundärübertragungselemente 21, 22 und Elektronikkomponenten 20 trägt. An ihrem sich gegenüberstehenden Seiten sind die Energieübertragungswand 15 und die Leiterplatte 2 so ausgebildet, dass sie aufeinander gesetzt und abdichtend miteinander verbunden werden können, um das Teilnehmergerät zu ergeben. Datensignal und Energieversorgungsspannung werden kapazitiv somit über die Kondensatorenplatten als die Übertragungselemente 11, 21 und 12, 22 an die elektronische Schaltung mit den Elektronikkomponenten 20 gekoppelt.

Fig. 4 zeigt, wie schmal gebaut das Gehäuse 10 eines Teilnehmergeräts sein kann. Es kann beispielsweise eine Baubreite, in Schienenlängsrichtung gemessen, von nur 6 mm erzielt werden.

Fig. 5 zeigt eine Anzahl von Teilnehmergeräten auf einer Schiene 5 aufgesteckt.

Die Fig. 6 zeigt als Seitenansicht einen Querschnitt durch ein Teilnehmergerät.

Auf Basis der Erfindung ist es möglich, Interface-Produkte in Baubreiten kleiner als 6 mm herzustellen. Zugleich bleibt aufgrund der platzsparenden Energieübertragung innerhalb des Gehäuses 10 genügend Raum, der dazu genutzt werden kann, weitere elektronische Komponenten unterbringen.

Die Transformatoren 11/21 und 12/22 können auch über je einen magnetischen Kern verbunden sein (nicht dargestellt). Dieser ist vorteilhaft mit einem oder mehreren Luftspalten ausgebildet.

Die Primärspulen 11, 12 sind in der Energie-Übertragungswand 15 mittels MID-Technologie isoliert aufgebaut. Auch andere Einkapselverfahren können angewandt werden.

Optional ist eine feste und dauerhafte Verbindung der Energie-Übertragungswand 15 und der zusätzlichen Leiterplatte 2mit integrierter Elektronik zur Bildung des Teilnehmergerätes herstellbar, dessen Teile 2 und 15 gleichzeitig das Gehäuse 10 bilden. Die Leiterplatte 2 enthält die Sekundärspulen 21, 22. Mit dem Anbringen der Leiterplatte 2 an die Energie-Übertragungswand 15 ist das Teilnehmergerät betriebsbereit.

Infolge des kurzen Abstandes zwischen Primärspule 11, 12 und Sekundärspule 21, 22 ist es möglich, die Leistung effizient zu übertragen.

Das Gehäuse 10 mit einer Baubreite von typischerweise 6,2 mm wird auf der Tragschiene 5 aufgerastet und erhält über die Anschlusseinrichtung 3 die benötigten Energieversorgungsspannungen und die Datensignale. Das Bussystem 4 umfasst in diesem Ausführungsbeispiel vier Leitungen: zwei für die Energieversorgung E1, E2 und zwei für die Signalversorgung S1, S2.

Im Falle der Ausführungsform nach Fig. 6 können die Gehäusehälften 13, 14 durch Klebung oder Schweißung miteinander verbunden werden. Die Leiterplatte 2 mit den elektronischen Komponenten 20 wird dadurch im Gehäuse 10 gekapselt. Die Geräte können deshalb auch für explosionsgefährdete Gebiete eingesetzt werden. Auch die Anbindung an die Stecker 30 kann gekapselt ausgeführt werden.

Die Einspeiseelektronik 16, 17 kann aus passiven und aktiven Bauteilen bestehen oder auch nur einen einzigen Resonanzkondensator enthalten. Wenn Eigenresonanzeffekte der Spulen ausgenutzt werden können, kann unter Umständen sogar auf einen Resonanzkondensator verzichtet werden.

Das Gehäuse 10 kann auch zur Unterbringung von mehreren Leiterplatten 2 ausgebildet werden. Durch die spezielle Gehäuseform und Form der Leiterplatte können definierte Positionierungen zwischen Gehäuse 10 und Leiterplatten 2 sichergestellt werden. Auf, unter oder innerhalb der Leiterplatte 2 können die Elektronikkomponenten 20 der elektronischen Schaltung untergebracht sein. Auch die daran angeschlossene Sekundärübertragungselementen 21, 22 können entweder in die Leiterplatte 2 integriert oder auf äußeren Schichten angeordnet sein.

Zu Abschirmzwecken kann das Gehäuse jeden Teilnehmergerätes eine magnetisch wirkende Platte oder eine umhüllende Ferritfolie enthalten. Auch die Verwendung von Metallblech aus zum Beispiel Kupfer oder Aluminium zu Abschirmzwecken ist möglich. Eine Kombination aus magnetisch wirkenden und elektrisch leitfähigen Materialschichten ist ebenfalls möglich.

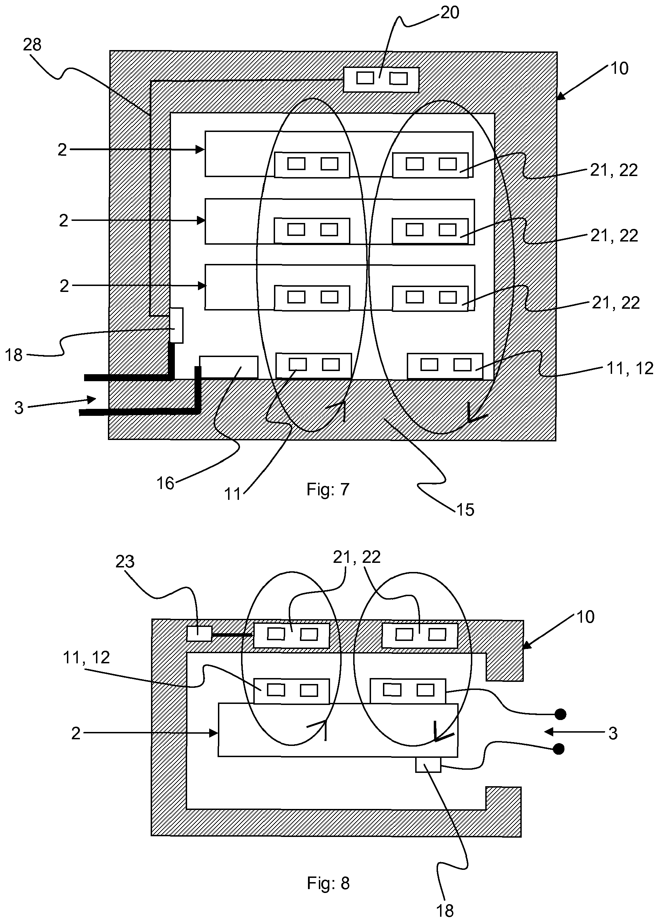

Fig. 7 zeigt in schematischer Darstellung ein elektrisches Gerät mit mehreren Leiterplatten 2 und elektromagnetischer Energie- bzw. Informationsübertragung über Flachspulen als Primär- und Sekundärübertragungselemente 11, 21 zu Energieversorgungszwecken bzw. Informationsübertragungszwecken. Das Primärübertragungselement 11 ist an der Innenseite der isolierenden Gehäusewand 15 angeordnet gezeigt; das Übertragungselement 11 kann aber auch im Inneren der Gehäusewand 15 eingekapselt angeordnet werden. In gleicher Weise wie die Energieübertragungselemente 11, 21 können auch die Informationsübertragungselemente 12, 22 vorgesehen und angeordnet werden. Die Fig. 7 zeigt eine als Leitungszuführung ausgebildete Anschlusseinrichtung 3, die mit einer Einspeiselektronik 16 verbunden ist, welche wiederum das Übertragungselement 11 speist. Dieses erzeugt das durch Ringpfeile angedeutete elektromagnetische Wechselfeld, das die Übertragungselemente 21, 22 beaufschlagt und je nach Verwendungsart die Energieversorgung und/oder die Signalversorgung der Leiterplatten 2 bewerkstelligt. In oder auf den Leiterplatten 2 sind Elektronikkomponenten untergebracht, was nicht dargestellt worden ist. Innerhalb der isolierenden Wände des Gehäuses 10 können sich weitere Elektronikkomponenten 20 befinden, die von der Anschlusseinrichtung 3, gegebenenfalls über eine Einspeiseelektronik 18 und über Leitungen 28 versorgt werden, die im Inneren von isolierenden Gehäusewänden, oder an deren Innenseite, verlaufen. Das in wesentlichen Teilen isolierend ausgebildete Gehäuse 10 kann staubdicht oder sogar gasdicht ausgebildet werden, um für explosionsgefährdete Bereiche geeignet zu sein.

Fig. 8 umfasst eine schematische Darstellung eines elektrischen Gerätes mit einer Identifikationseinrichtung. Zu diesem Zweck ist ein RFID-Bauteil 23 in einer isolierenden Wandung des Gehäuses 10 eingekapselt enthalten und kann beispielsweise durch ein nicht dargestelltes Lesegerät ausgelesen werden. Im Inneren des Gehäuses 10 befindet sich die Leiterplatte 2 (es können auch mehrere Leiterplatten sein) welche elektromagnetisch wirksame Übertragungselemente 11, 12 trägt oder im Inneren beherbergt, die über die Anschlusseinrichtung 3 und gegebenenfalls Einspeiseelektronik 18 angesteuert werden können. Innerhalb isolierender Wandteile des Gehäuses 10 befinden sich elektromagnetisch wirksame Übertragungselemente 21, 22 die wie die Übertragungselemente 11, 12 aus Flachspulen bestehen können. Wenn die Übertragungselemente 11, 12 erregt werden und die Übertragungselemente 21, 22 den Übertragungselementen 11, 12 gegenüber stehen, kann die korrekte Montage der Leiterplatte 2 durch Ansprechen des RFID-Bauteils 23 überprüft werden. Auch die Überprüfung zu Zwecken des Plagiatschutzes ist möglich. Die dargestellte offene Bauweise des Gehäuses 10 ist nicht zwingend. Es kann eine geschlossene Bauweise gewählt werden.

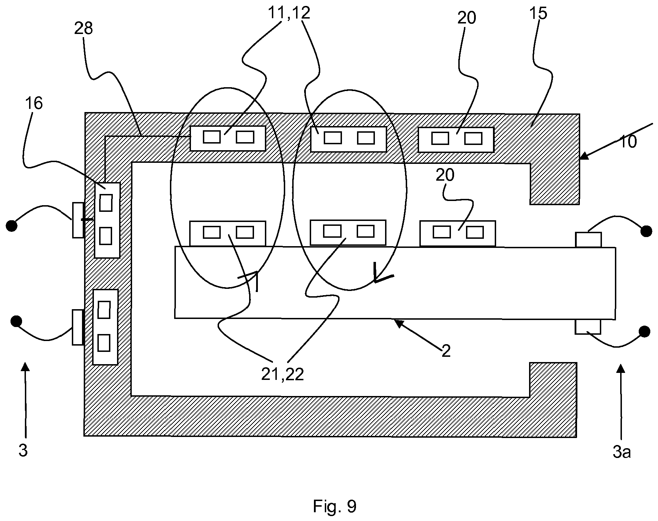

Fig. 9 zeigt in schematischer Darstellung ein elektrisches Gerät mit Trennverstärkerfunktion. Die primärseitigen elektromagnetisch wirksamen Übertragungselemente 11, 12 sind in der isolierenden Wandung 15 des Gehäuses 10 eingekapselt enthalten und können, ausgehend von der Anschlusseinrichtung 3 über eine Einspeiseelektronik 16 mit hochfrequentem Erregerstrom betrieben werden. Die sekundärseitigen elektromagnetisch wirksamen Übertragungselemente 21, 22 sind auf oder in der Leiterplatte 2 angeordnet. Elektronikkomponenten 20 können in isolierenden Wandungen des Gehäuses 10 und in oder auf der Leiterplatte 2 untergebracht werden. Die Leiterplatte 2 verfügt über eine weitere Anschlusseinrichtung 3a, die es ermöglicht, elektrische Energie an weitere Geräte zu Zwecken der Energieversorgung und/oder Informationsübermittlung abzugeben.

Indem Elektronikkomponenten 20 und elektromagnetisch wirksame Übertragungselemente 11, 12, 21, 22 innerhalb von isolierenden Wänden des Gehäuses 10 oder der Leiterplatte 2 angeordnet werden, kann eine optimale Platzausnutzung bei kompakter Bauform erreicht werden. Ferner wird eine galvanische Trennung zwischen Gehäuse 10 und Leiterplatte 2 erreicht. Indem Kunststoff als isolierendes Gehäusematerial verwendet wird und/oder der möglicherweise entstehende Hohlraum mit einem elektrisch isolierenden Medium gefüllt wird, kann eine gute Isolation (Spannungsfestigkeit) durch Kapselung der Gehäuseelektronik 20 erzielt werden.

### Bezugszeichen

- 1: Teilnehmergerät
- 2: Leiterplatte
- 3: Anschlusseinrichtung
- 3a: weitere Anschlusseinrichtung
- 4: Bussystem
- 5: Tragschiene
- 10: Gehäuse
- 11: Primärübertragungselement
- 12: Primärübertragungselement
- 13: Gehäuseteil
- 14: Gehäuseteil
- 15: Energie-Übertragungswand
- 16: Einspeiseelektronik
- 17: Einspeiseelektronik
- 18: Einspeiseelektronik
- 20: Elektronikkomponente
- 21: Sekundärübertragungselement
- 22: Sekundärübertragungselement
- 23: RFID-Bauteil
- 28: Leitung
- 30: Stecker bzw. Kontaktvorrichtung
- 31: Verbindungsleitung
- 32: Verbindungsleitung
- 33: Verbindungsleitung
- 34: Verbindungsleitung
- E1,E2: Leitungen für die Energieversorgung
- S1,S2: Leitungen für das Datensignal

## Patentansprüche

1. Modulares Elektroniksystem zur Aufnahme, Verarbeitung oder Weitergabe von Information, umfassend:
- mindestens eine Leiterplatte (2) mit Elektronikkomponenten (20) und mit einem oder mehreren elektromagnetisch wirksamen Übertragungselementen (21, 22),
- ein Gehäuse (10) mit Hohlraum zur Aufnahme der mindestens einen Leiterplatte (2) und mit elektromagnetisch wirksamen Übertragungselementen (11, 12) an oder in wenigstens einer Wandung (15) des Gehäuses,
- eine Anschlusseinrichtung (3) zur Zufuhr von elektrischer Energie und/oder zu Informationsübermittlungszwecken,
- wobei die Anschlusseinrichtung (3) mit elektromagnetisch wirksamen Übertragungselementen des Gehäuses (10) und/oder der mindestens einen Leiterplatte (2) in elektrischer oder elektromagnetischer Verbindung steht, und
- wobei die elektromagnetisch wirksamen Übertragungselemente (11, 12) des Gehäuses (10) und die elektromagnetisch wirksamen Übertragungselemente (21, 22) der mindestens einen Leiterplatte (2), soweit sie sich gegenüberstehen, flach ausgebildet sind und zur elektromagnetischen Kopplung angeordnet sind.

2. Modulares Elektroniksystem nach Anspruch 1,
wobei die mindestens eine Leiterplatte (2) Teil der Gehäusewandung oder eines in MID-Technik hergestellten, Übertragungselemente (21, 22) aufnehmenden Elementes bildet.

3. Modulares Elektroniksystem nach einem der Ansprüche 1 oder 2,
wobei das Gehäuse (10) wenigstens im Bereich der Übertragungselemente (11, 12) elektrisch isolierend ausgebildet ist.

4. Modulares Elektroniksystem nach einem der Ansprüche 1 bis 3,
wobei das Primärteil der elektromagnetisch wirksamen Übertragungselemente im Gehäuse (10) und das Sekundärteil auf der mindestens einen Leiterplatte (2) angeordnet sind.

5. Modulares Elektroniksystem nach Anspruch 4,
wobei die mindestens eine Leiterplatte (2) eine weiterführende Anschlusseinrichtung (3a) aufweist.

6. Modulares Elektroniksystem nach einem der Ansprüche 1 bis 5,
wobei die Elektronikkomponenten (20) ein RFID-Bauteil (23) aufweisen, das in einer isolierenden Wandung des Gehäuses (10) untergebracht ist.

7. Modulares Elektroniksystem nach einem der Ansprüche 1 bis 6, umfassend:
- ein Bussystem (4)
- eine Anzahl von Teilnehmergeräten (1), die an das Bussystem (4) über jeweils eine Anschlusseinrichtung (3) angeschlossen sind und die nebeneinander an einer Trägerschiene (5) befestigt und untergebracht werden können,
- eine Energie-Übertragungswand (15), die dem jeweiligen Teilnehmergerät (1) angehört und die mindestens ein flach ausgebildetes, elektromagnetisch wirksames Primärübertragungselement (11) eingeschlossen enthält, und
- die wenigstens eine Leiterplatte (2), die neben Elektronikkomponenten (20) noch mindestens ein flach ausgebildetes elektromagnetisch wirksames Sekundärübertragungselement (21) enthält, das Gleichrichterbauteile zur Stromversorgung der Elektronikkomponenten (20) speist und das dem mindestens einen Primärübertragungselement (11) in dem Teilnehmergerät (1) zur gegenseitigen Zusammenarbeit durch Kopplung über ein elektromagnetisches Wechselfeld eng gegenübersteht.

8. Modulares Elektroniksystem nach Anspruch 7,
wobei das Teilnehmergerät (1) ein aus Gehäuseteilen (13, 14) aufgebautes Gehäuse (10) aufweist, von dem die Energie-Übertragungswand (15) einen Teil bildet.

9. Modulares Elektroniksystem nach Anspruch 7 oder 8,
wobei die Energie-Übertragungswand (15) ein zweites Primärübertragungselement (12) aufweist, das mit einem zweiten Sekundärübertragungselement (22) der wenigstens einen Leiterplatte (2) zur gegenseitigen Zusammenarbeit durch Kopplung über ein elektromagnetisches Wechselfeld eng gegenübersteht und das der Signalübermittlung dient.

10. Modulares Elektroniksystem nach einem der Ansprüche 7 bis 9,
wobei jedes Primärübertragungselement (11, 12) mit einer zugeordneten Einspeiseelektronik (16, 17) verbunden ist, das in der Energie-Übertragungswand (15) eingekapselt enthalten ist.

11. Modulares Elektroniksystem nach einem der Ansprüche 7 bis 10,
wobei die Trägerschiene (5) Energieleitungen (E1, E2) und Signalleitungen (S1, S2) haltert, die dem Bussystem (4) angehören und die über die Anschlusseinrichtung (3) mit jeweiligen Teilnehmergeräten (1) verbunden sind.

12. Modulares Elektroniksystem nach Anspruch 11 in Rückbezug auf Anspruch 10,
wobei die Anschlusseinrichtung (3) über Stecker (30) und zu der Einspeiseelektronik (16, 17) führenden Leitungen (31, 32, 33, 34) verfügt.

13. Modulares Elektroniksystem nach Anspruch 11,
wobei die Anschlusseinrichtung (3) über Primär- und Sekundärübertragerelemente verfügt, um als induktiver oder kapazitiver Übertrager wirksam zu sein.

14. Busteilnehmergerät für ein modulares Elektroniksystem, umfassend:
ein Gehäuse (10) aus elektrisch isoliertem Material,
das eine Energie-Übertragungswand (15) und wenigstens eine Leiterplatte (2) mit Elektronikkomponenten (20) enthält und das an einer Trägerschiene (5) befestigbar ist,
wobei die Energie-Übertragungswand (15) in eingekapselter Form wenigstens ein flaches elektromagnetisch wirksames Primärübertragungselement (11) für Energieübertragung und wenigstens ein flaches elektromagnetisch wirksames Primärübertragungselement (12) für Signalübertragung aufweist, und
die Leiterplatte (2) wenigstens ein flaches elektromagnetisch wirksames Sekundärübertragungselement (21) für Energieversorgungszwecke und ein flaches elektromagnetisch wirksames Sekundärübertragungselement (22) für Signalempfang und Signalsendung aufweist, die zur Kopplung den Primärübertragungselementen (11, 12) eng gegenüberstehen.

## Claims

1. A modular electronic system for receiving, processing or forwarding information, comprising:
- at least one circuit board (2) including electronic components (20) and one or more electromagnetically effective transfer elements (21, 22);
- a housing (10) having a cavity for accommodating the at least one circuit board (2) and comprising electronic components (20) and/or electromagnetically effective transfer elements (11, 12) on or in at least one wall (15) of the housing;
- connection means (3) for feeding electrical power and/or for information transfer purposes;
- wherein the connection means (3) are electrically or electromagnetically coupled with electromagnetically effective transfer elements of the housing (10) and/or of the at least one circuit board (2); and
- wherein the electromagnetically effective transfer elements (11, 12) of the housing (10) and the electromagnetically effective transfer elements (21, 22) of the at least one circuit board (2) are flat in a region where they face each other and are arranged for electromagnetic coupling.

2. The modular electronic system according to claim 1,
wherein the at least one circuit board (2) forms part of the housing wall or of an element accommodating transfer elements (21, 22) and produced in MID technology.

3. The modular electronic system according to any one of claims 1 or 2,
wherein the housing (10) is designed to be electrically insulating at least in the region of the transfer elements (11, 12).

4. The modular electronic system according to any one of claims 1 to 3,
wherein the primary component of the electromagnetically effective transfer elements is arranged in the housing (10) and the secondary component is arranged on the at least one circuit board (2).

5. The modular electronic system according to claim 4,
wherein the at least one circuit board (2) has a further connection means (3a).

6. The modular electronic system according to any one of claims 1 to 5,
wherein the electronic components (20) include an RFID component (23) which is accommodated in an insulating wall of the housing (10).

7. The modular electronic system according to any one of claims 1 to 6, comprising:
- a bus system (4);
- a number of subscriber devices (1) each one connected to the bus system (4) via a respective connection means (3), which subscriber devices can be mounted and accommodated side by side on a support rail (5);
- an energy transfer wall (15) forming part of the respective subscriber device (1) and including at least one flat electromagnetically effective primary transfer element (11) enclosed therein; and
- the at least one circuit board (2) which in addition to the electronic components (20) includes at least one flat electromagnetically effective secondary transfer element (21) for feeding rectifier components for power supply of the electronic components (20), which secondary transfer element is arranged so as to closely face the at least one primary transfer element (11) in the subscriber device (1) for interaction by being coupled through an electromagnetic alternating field.

8. The modular electronic system according to claim 7,
wherein the subscriber device (1) includes a housing (10) comprising housing parts (13, 14), one part thereof being the energy transfer wall (15).

9. The modular electronic system according to claim 7 or 8, wherein the energy transfer wall (15) includes a second primary transfer element (12) closely facing a second secondary transfer element (22) of the at least one circuit board (2) for interaction by being coupled through an electromagnetic alternating field and used for signal transfer.

10. The modular electronic system according to any one of claims 7 to 9,
wherein each primary transfer element (11, 12) is connected to respective associated feed electronics (16, 17) encapsulated in the energy transfer wall (15).

11. The modular electronic system according to any one of claims 7 to 10,
wherein the support rail (5) supports power supply lines (E1, E2) and signal lines (S1, S2) which belong to the bus system (4) and which are connected to respective subscriber devices (1) via the connection means (3).

12. The modular electronic system according to claim 11 when dependent on claim 10,
wherein the connection means (3) comprise male connectors (30) and lines (31, 32, 33, 34) leading to the feed electronics (16, 17).

13. The modular electronic system according to claim 11,
wherein the connection means (3) comprise primary and secondary transfer elements so as to be effective as an inductive or capacitive transformer.

14. A bus subscriber device for a modular electronic system, comprising:
a housing (10) made of electrically insulating material, comprising an energy transfer wall (15) and at least one circuit board (2) including electronic components (20), and which can be mounted to a support rail (5);
wherein the energy transfer wall (15) includes at least one flat electromagnetically effective primary transfer element (11) encapsulated therein for power transfer purposes, and at least one flat electromagnetically effective primary transfer element (12) encapsulated therein for signal transfer purposes; and
wherein the circuit board (2) includes at least one flat electromagnetically effective secondary transfer element (21) for power supply purposes and one flat electromagnetically effective secondary transfer element (22) for reception and transmission of signals, which secondary transfer elements are arranged so as to closely face the primary transfer elements (11, 12), for coupling purposes.

## Revendications

1. Système électronique modulaire destiné à recevoir, traiter ou communiquer des informations, comprenant :
- au moins un circuit imprimé (2) avec des composants électroniques (20) et avec un ou plusieurs éléments de transmission (21, 22) électromagnétiquement opérationnels,
- un boîtier (10) avec une cavité pour recevoir l'au moins un circuit imprimé (2) et avec des éléments de transmission (11, 12) électromagnétiquement opérationnels contre ou dans au moins une paroi (15) du boîtier,
- un dispositif de raccordement (3) pour conduire une énergie électrique et/ou à des fins de passation d'informations,
- dans lequel le dispositif de raccordement (3) est en liaison électrique ou électromagnétique avec des éléments de transmission électromagnétiquement opérationnels du boîtier (10) et/ou de l'au moins un circuit imprimé (2), et
- dans lequel les éléments de transmission (11, 12) électromagnétiquement opérationnels du boîtier (10) et les éléments de transmission (21, 22) électromagnétiquement opérationnels de l'au moins un circuit imprimé (2), dans la mesure où ils se font face, sont conçus de façon plate et sont agencés pour créer un couplage électromagnétique.

2. Système électronique modulaire selon la revendication 1, dans lequel l'au moins un circuit imprimé (2) constitue une partie de la paroi de boîtier ou d'un élément recevant des éléments de transmission (21, 22) fabriqués avec la technique MID.

3. Système électronique modulaire selon l'une des revendications 1 ou 2, dans lequel le boîtier (10) est conçu de façon électriquement isolante au moins dans la région des éléments de transmission (11, 12).

4. Système électronique modulaire selon l'une des revendications 1 à 3, dans lequel la partie primaire des éléments de transmission électromagnétiquement opérationnels dans le boîtier (10) et la partie secondaire sont agencées sur l'au moins un circuit imprimé (2).

5. Système électronique modulaire selon la revendication 4, dans lequel l'au moins un circuit imprimé (2) présente un dispositif de raccordement (3a) complémentaire.

6. Système électronique modulaire selon l'une des revendications 1 à 5, dans lequel les composants électroniques (20) présentent un élément RFID (23) qui est logé dans une paroi isolante du boîtier (10).

7. Système électronique modulaire selon l'une des revendications 1 à 6, comprenant :
- un système de bus (4)
- un certain nombre d'appareils d'utilisateur (1) qui sont raccordés au système de bus (4) via respectivement un dispositif de raccordement (3) et qui peuvent être fixés et logés les uns à côté des autres sur un rail de support (5),
- une paroi de transmission d'énergie (15) qui appartient à l'appareil d'utilisateur (1) respectif et qui contient inclus au moins un élément de transmission primaire (11) électromagnétiquement opérationnel conçu de façon plate, et
- l'au moins un circuit imprimé (2), qui en plus de composants électroniques (20) contient également au moins un élément de transmission secondaire (21) électromagnétiquement opérationnel conçu de façon plate qui alimente des éléments de redresseur pour une alimentation en courant des composants électroniques (20) et qui fait étroitement face à l'au moins un élément de transmission primaire (11) dans l'appareil d'utilisateur (1) pour une coopération mutuelle par un couplage via un champ alternatif électromagnétique.

8. Système électronique modulaire selon la revendication 7, dans lequel l'appareil d'utilisateur (1) présente un boîtier (10) composé de parties de boîtier (13, 14) dont la paroi de transmission d'énergie (15) constitue une partie.

9. Système électronique modulaire selon la revendication 7 ou 8, dans lequel la paroi de transmission d'énergie (15) présente un second élément de transmission primaire (12) qui fait étroitement face à un second élément de transmission secondaire (22) de l'au moins un circuit imprimé (2) pour une coopération mutuelle par un couplage via un champ alternatif électromagnétique et qui sert à la retransmission de signaux.

10. Système électronique modulaire selon l'une des revendications 7 à 9, dans lequel chaque élément de transmission primaire (11, 12) est raccordé à une électronique d'alimentation (16, 17) attribuée, qui est contenue par encapsulation dans la paroi de transmission d'énergie (15).

11. Système électronique modulaire selon l'une des revendications 7 à 10, dans lequel le rail de support (5) supporte des lignes d'énergie (E1, E2) et des lignes de signaux (S1, S2) qui appartiennent au système de bus (4) et qui sont raccordées à des appareils d'utilisateur (1) respectifs via le dispositif de raccordement (3).

12. Système électronique modulaire selon la revendication 11 lorsqu'elle dépend de la revendication 10, dans lequel le dispositif de raccordement (3) dispose de prises (30) et de lignes (31, 32, 33, 34) conduisant vers l'électronique d'alimentation (16, 17).

13. Système électronique modulaire selon la revendication 11, dans lequel le dispositif de raccordement (3) dispose d'éléments de transmission primaire et secondaire pour être opérationnel en tant que transmetteur inductif ou capacitif.

14. Appareil de participant de bus pour un système électronique modulaire, comprenant :
un boîtier (10) fabriqué dans un matériau électriquement isolant, qui contient une paroi de transmission d'énergie (15) et au moins un circuit imprimé (2) avec des composants électroniques (20) et qui peut être fixé sur un rail de support (5),
dans lequel la paroi de transmission d'énergie (15) présente sous une forme encapsulée au moins un élément de transmission primaire (11) électromagnétiquement opérationnel et plat pour une transmission d'énergie et au moins un élément de transmission primaire (12) électromagnétiquement opérationnel et plat pour une transmission de signal, et
le circuit imprimé (2) présente au moins un élément de transmission secondaire (21) électromagnétiquement opérationnel et plat à des fins d'alimentation en énergie et un élément de transmission secondaire (22) électromagnétiquement opérationnel et plat pour une réception de signal et une émission de signal, qui pour un couplage font étroitement face aux éléments de transmission primaires (11, 12).
